(19) Europäisches Patentamt / European Patent Office / Office européen des brevets

(11) **EP 3 320 356 B1**

(12) **FASCICULE DE BREVET EUROPEEN**

(45) Date de publication et mention de la délivrance du brevet:
**25.05.2022 Bulletin 2022/21**

(21) Numéro de dépôt: **16741572.8**

(22) Date de dépôt: **08.07.2016**

(51) Classification Internationale des Brevets (IPC):
*G01R 33/00* (2006.01)    *G01V 3/08* (2006.01)

(52) Classification Coopérative des Brevets (CPC):
**G01R 33/0064; G01V 3/081;** G01V 2003/086

(86) Numéro de dépôt international:
**PCT/EP2016/066323**

(87) Numéro de publication internationale:
**WO 2017/005915 (12.01.2017 Gazette 2017/02)**

(54) **PROCÉDÉ DE LOCALISATION D'UN OBJET MAGNÉTIQUE**

VERFAHREN ZUR ORTUNG EINES MAGNETISCHEN OBJEKTS

METHOD FOR LOCATING A MAGNETIC OBJECT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.07.2015 FR 1556501**

(43) Date de publication de la demande:
**16.05.2018 Bulletin 2018/20**

(73) Titulaire: **Commissariat à l'Énergie Atomique et aux Énergies Alternatives**
**75015 Paris (FR)**

(72) Inventeurs:
• **VIANA, Antoine**
**38320 Herbeys (FR)**
• **ALOUI, Saifeddine**
**38600 Fontaine (FR)**

(74) Mandataire: **Marks & Clerk France**
**Immeuble "Visium"**
**22, avenue Aristide Briand**
**94117 Arcueil Cedex (FR)**

(56) Documents cités:
**EP-A1- 2 378 305    EP-A1- 2 889 648**

• **MARTIN SCHEPERS H ET AL: "Ambulatory human motion tracking by fusion of inertial and magnetic sensing with adaptive actuation", MEDICAL & BIOLOGICAL ENGINEERING & COMPUTING, SPRINGER, BERLIN, DE, vol. 48, no. 1, 17 décembre 2009 (2009-12-17), pages 27-37, XP019835465, ISSN: 1741-0444**
• **NORMAN DERBY ET AL: "Cylindrical Magnets and Ideal Solenoids", ARXIV.ORG, CORNELL UNIVERSITY LIBRARY, 201 OLIN LIBRARY CORNELL UNIVERSITY ITHACA, NY 14853, 22 September 2009 (2009-09-22), XP080367759, DOI: 10.1119/1.3256157**

**Description**

L'invention concerne un procédé permettant de déterminer la localisation et/ou l'orientation d'une source de champ magnétique dans l'espace.

Les appareils de détection des mouvements dans l'espace par des capteurs de champ magnétiques, ou magnétomètres, se composent généralement d'une série de capteurs de champ magnétiques, d'un ou plusieurs aimants et d'un ou plusieurs objets dont on veut détecter les mouvements.

Une première méthode consiste à détecter le champ magnétique émis par un aimant fixe. Le mouvement d'un l'objet induit des variations du champ magnétique qui sont détectées par des capteurs fixes. Ces variations sont ensuite ajustées à un modèle pour en déduire le mouvement de l'objet. Dans US 4,785,242, un mouvement à un degré de liberté (rotation) est détecté de cette manière.

Une seconde méthode consiste à lier de manière solidaire les sources de champ magnétique et les objets à détecter. Yan, L. et al. présentent dans An Orientation Measurement Method Based on Hall-effect Sensors for Permanent Magnet Spherical Actuators with 3D Magnet Array (Scientific reports, 4., 2014) une méthode pour détecter la rotation à trois degrés de liberté d'un rotor lié à des aimants permanents. Le champ magnétique est détecté par des capteurs à effet Hall, et le mouvement est calculé par un ajustement des données basé sur une approximation exponentielle.

Une limitation de ces méthodes de détection provient de la difficulté de corréler les signaux des capteurs avec un modèle analytique ou numérique du champ magnétique en trois dimensions.

WO2013144342 divulgue un procédé et un dispositif de détermination de la localisation et de l'orientation d'un objet magnétique en utilisant un réseau de capteurs de champ magnétique tri-axes, permettant au capteur de déterminer le sens et l'amplitude de l'induction magnétique au point de mesure. Lorsque le champ magnétique a été mesuré par tous ou une partie des capteurs, le dispositif implémente un modèle mathématique associant chaque mesure de capteur à la position et à l'orientation de la source de champ magnétique dans l'espace. Le modèle utilisé effectue une approximation de la source de champ magnétique par un dipôle magnétique et est implémenté sous la forme d'un filtre de Kalman. Les demandes de brevet Européen EP 2 889 648 A1 et EP 2 378 305 A1 décrivent également des dispositifs utilisant des modèles dipolaires pour mesurer le champ magnétique. EP2889648 A1 décrit un procédé de détermination de la position relative dans l'espace d'au moins deux sources de champ magnétique par rapport à au moins un capteur de champ magnétique comprenant les étapes consistant à : a) acquérir des mesures du champ magnétique généré par lesdites sources de champ magnétique au moyen dudit au moins un capteur de champ magnétique; b) calculer au moyen d'au moins un processeur une solution de l'expression du champ magnétique généré par au moins une dite source de champ magnétique en modélisant chaque dite source de champ magnétique par un élément choisi parmi une superposition de solénoïdes et une superposition de plans chargés; c) calculer au moins un élément choisi parmi la position et l'orientation de chaque dite source de champ magnétique en utilisant au moins une méthode choisie parmi : - une minimisation du coût entre lesdites mesures dudit au moins un capteur de champ magnétique et lesdites solutions calculées à l'étape b); - un filtrage bayésien, à des instants successifs, de chaque dite mesure de chacun dudit au moins un capteur de champ magnétique, ledit filtrage étant fonction de chaque dite solution calculée à l'étape b).

L'utilisation d'un modèle dipolaire présente l'avantage d'être compatible avec la charge de calcul réalisable par un processeur usuel. En revanche, ce modèle possède une précision limitée. Il introduit en particulier des erreurs importantes si la source magnétique, de dimension maximum L, est située à une distance inférieure à 10L d'un capteur de champ magnétique. L'erreur entre le champ magnétique mesuré par le capteur et le champ magnétique selon un modèle dipolaire à l'endroit du capteur augmente quand la source de champ magnétique se rapproche du capteur, pour diverger quand la source de champ magnétique et le capteur magnétique tendent vers le même point. L'implémentation d'un modèle prenant en compte la géométrie exacte de la source de champ magnétique serait avantageuse pour calculer avec précision la localisation et l'orientation d'une source proche d'un capteur, située par exemple à une distance inférieure à 10L d'un capteur, mais peut représenter une charge de calcul incompatible avec la charge de calcul imposable au processeur pour un traitement des données en temps réel. C'est le cas par exemple dans l'article de Martin Schepers H et al, Ambulatory human motion tracking by fusion of intertial and magnetic sensing with adaptive actuation, Médical & biological engineering & computing, Springer, Berlin, DE, vol. 48, no. 1, 17 décembre 2009, pages 27-37, où la charge de calcul est maitrisée en limitant au maximum les calculs de champ magnétique.

L'invention a pour but de surmonter les inconvénients précités de l'art antérieur. Plus particulièrement, elle vise à surmonter les limitations des modèles dipolaires tout en maintenant un niveau de complexité computationnelle acceptable, notamment pour des applications en temps réel utilisant un processeur embarqué dans un appareil portable.

Un objet de l'invention permettant d'atteindre ce but est un procédé de détermination de la position relative dans l'espace d'au moins deux sources de champ magnétique par rapport à au moins un capteur de champ magnétique comprenant les étapes consistant à :

a) acquérir des mesures du champ magnétique généré par les dites lesdites sources de champ magnétique (3) au moyen dudit au moins un capteur de champ magnétique (4);

b) calculer au moyen d'au moins un processeur une solution de l'expression du champ magnétique généré par les sources de champ magnétique (3) en modélisant chaque dite source de champ magnétique (3) par un élément choisi parmi une superposition de solénoïdes et une superposition de plans chargés, puis en estimant la valeur d'une intégrale elliptique complète liée au dit modèle par un algorithme itératif de Bulirsch utilisant une transformation de Landen; c) calculer au moins un élément choisi parmi la position et l'orientation de chaque dite source de champ magnétique (3) en utilisant au moins une méthode choisie parmi : - une minimisation du coût entre lesdites mesures dudit au moins un capteur de champ magnétique (4) et lesdites solutions calculées à l'étape b) ; - un filtrage bayésien, à des instants successifs, de chaque dite mesure de chacun dudit au moins un capteur de champ magnétique (4), ledit filtrage étant fonction de chaque dite solution calculée à l'étape b), le procédé comprenant en outre la commande d'une émission périodique de l'intensité du champ magnétique dudit solénoïde à une fréquence différente d'au moins une autre desdites sources de champ magnétique (3).

Avantageusement, on choisit d'utiliser au moins un dit filtrage bayésien dans l'étape c) , ledit filtre bayésien étant un filtre de Kalman.

Avantageusement, au moins une desdites au moins deux sources de champ magnétique est en mouvement par rapport au dit au moins un capteur de champ magnétique et dans lequel au moins un élément choisi parmi la position et l'orientation d'au moins une desdites au moins deux sources de champ magnétique et la position et l'orientation dudit au moins un capteur dit capteur de champ magnétique est calculé à partir d'un filtrage de Kalman desdites mesures dudit au moins un capteur de champ magnétique, ledit filtrage de Kalman étant fonction de chaque dite solution calculée, à chacun desdits instants successifs.

Avantageusement, au moins une desdites au moins deux sources de champ magnétique peut être placée à moins de dix centimètres dudit au moins un capteur d'au moins un dit capteur de champ magnétique.

L'invention concerne aussi une interface homme/machine comportant au moins une dite source de champ magnétique, au moins un dit capteur de champ magnétique, et au moins une unité de traitement, au moins une unité de traitement étant programmée de manière opportune pour la mise en oeuvre de chaque étape d'un dit procédé.

Avantageusement, l'interface homme/machine comporte une pluralité de dits capteurs de champ magnétique, dans laquelle l'ensemble des dits capteurs de champ magnétique est un réseau non plan.

Avantageusement, au moins une desdites au moins deux sources de champ magnétique de ladite interface homme/machine est choisie parmi un solénoïde monocouche et un aimant cylindrique plein.

Avantageusement, l'interface homme/machine comporte au moins deux dites sources de champ magnétique, au moins une dite source de champ magnétique étant un solénoïde, et une dite unité de traitement de ladite interface est programmée pour commander une émission périodique de l'intensité du champ magnétique dudit solénoïde à une fréquence différente d'au moins une autre dite source de champ magnétique.

Avantageusement, au moins une desdites au moins deux sources de champ magnétique de ladite interface est un aimant permanent composé d'un alliage d'éléments choisis parmi le fer, le vanadium, le néodyme, le bore, l'aluminium, le nickel, le titane, le cuivre, le samarium et le cobalt.

On rappelle que, dans les matériaux paramagnétiques ou diamagnétiques, le vecteur H, mesuré en ampère par mètre (A/m) et qui est aussi appelé « champ magnétique » dans de nombreux ouvrages, est lié au vecteur B, appelé induction magnétique, mesurée en Tesla (T), par la relation $B = \mu(H).H + Br$, où **Br** est l'induction rémanente. La plupart des développements qui suivent demeurent valables si on s'intéresse au champ H au lieu du champ B dans la zone de linéarité entre B et H.

La description suivante présente plusieurs exemples de réalisation du dispositif de l'invention. Ces exemples de réalisation présentent à la fois les caractéristiques essentielles de l'invention ainsi que des caractéristiques additionnelles liées aux modes de réalisation considérés. Par souci de clarté, les mêmes éléments porteront les mêmes repères numériques dans les différentes figures.

L'invention sera mieux comprise et d'autres avantages, détails et caractéristiques de celle-ci apparaîtront au cours de la description explicative qui suit, faite à titre d'exemple en référence aux dessins annexés dans lesquels :

- la figure 1 présente une vue schématique de interface homme/machine ;

- la figure 2 présente la description d'un modèle ampérien d'une source de champ magnétique ;

- la figure 3 illustre l'utilisation du théorème de superposition dans une modélisation utilisée dans l'invention ;

- la figure 4 présente la description d'un modèle coulombien d'une source de champ magnétique ;

- la figure 5 illustre l'utilisation du théorème de superposition dans une modélisation utilisée dans l'invention ;

- la figure 6 présente la mise en oeuvre du problème du calcul de champ magnétique d'un solénoïde dans un référentiel cartésien ;

- la figure 7 présente une vue schématique du fonctionnement d'un filtre de Kalman.

Dans la suite du texte, le terme capteur de champ magnétique est définit par un capteur de champ magnétique tri-axe : la mesure du champ magnétique est effectuée sur trois axes différents de l'espace à l'endroit du capteur de champ magnétique.

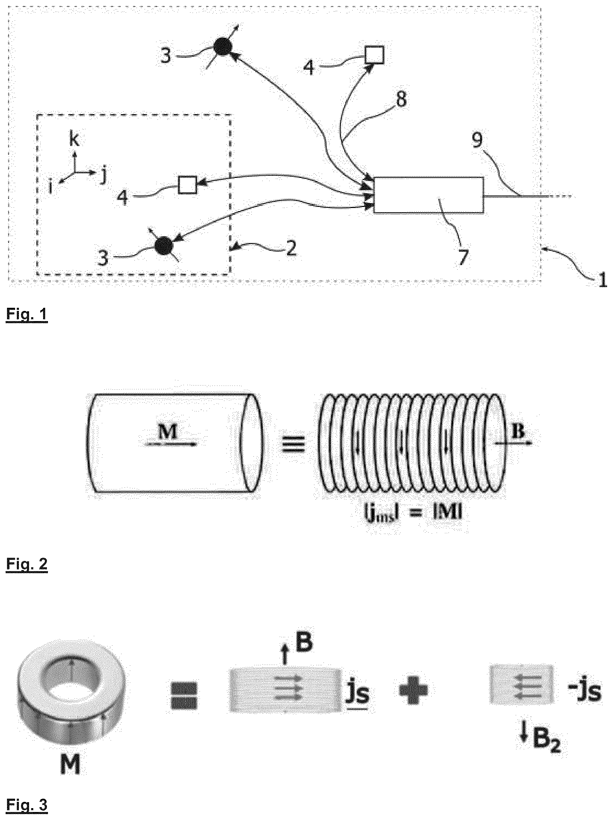

La figure 1 présente une vue schématique de l'interface homme/machine 1. L'interface homme/machine 1 peut comporter une ou plusieurs sources de champs magnétique 3, un ou plusieurs capteurs de champ magnétique 4, chacun reliés par un bus 8 à une unité de traitement 7. Le bus 8 est représenté sur la figure 1 par une double flèche : il peut être réalisé par une liaison de données filaire ou sans fil. Chacun des capteurs de champ magnétique 4 et des sources de champ magnétique 3 peut être mécaniquement indépendant, ou liés de manière solidaire. Dans la réalisation particulière illustrée par la figure 1, l'élément de repère 2 comporte un capteur de champ magnétique 4 et une source de champ magnétique 3, solidairement liés et fixes dans un repère (i,j,k) orthogonal. Dans la réalisation illustrée par la figure 1, une des deux sources de champ magnétique 3 n'appartient pas à l'élément de repère 2 et peut être déplacée librement par rapport au repère (i,j,k). De même, un des deux capteurs de champ magnétique 4 n'appartient pas à l'élément de repère 2 et peut être déplacé librement par rapport au repère (i,j,k). Pour réaliser une interface homme/machine 1, on peut par exemple lier de manière solidaire l'élément de repère 2 à une partie du corps humain, et lier le capteur de champ magnétique 4 et la source de champ magnétique 3 n'appartenant pas à l'élément de repère 2, à d'autres parties du corps humain, afin d'en mesurer les déplacements respectifs par rapport au repère (i,j,k).

Dans une réalisation particulière de l'invention, la source de champ magnétique 3 peut être un aimant permanent c'est-à-dire un aimant dont le moment magnétique est non nul en l'absence de champ magnétique extérieur. La forme de la source de champ magnétique 3 peut être un cylindre plein ou un cylindre troué. La source de champ magnétique 3 peut être fabriquée dans un alliage d'éléments choisis parmi le fer, le vanadium, le néodyme, le bore, l'aluminium, le nickel, le titane, le cuivre, le samarium et le cobalt.

Dans une réalisation particulière de l'invention, les capteurs de champ magnétique 4 d'un même élément de repère 2, lorsque le dispositif en utilise un nombre supérieur ou égal à quatre, ne sont pas coplanaires. Cette disposition permet d'obtenir des informations sur le gradient de champ magnétique pour chacun des axes définis en figure 1.

La source de champ magnétique 3 peut aussi être un solénoïde parcouru par un courant électrique alternatif.

L'interface homme/machine 1 peut comporter plusieurs sources de champ magnétique 3. Dans le cas où plusieurs de ces sources de champ magnétique 3 sont des solénoïdes parcourus par des courants alternatifs, on peut imposer une fréquence de variation du courant électrique particulière à chacun des solénoïdes, dans le but de différentier les sources de champ magnétiques 3 lors de leur détection.

Plus généralement, dans des réalisations de l'invention, l'interface homme/machine peut comporter au moins une source de champ 3 réalisée par un solénoïde; l'unité de traitement 7 peut être programmée pour commander une émission périodique de l'intensité du champ magnétique dudit solénoïde, à une fréquence différente d'au moins une autre fréquence d'émission du champ magnétique d'une autre source de champ magnétique 3. Cette caractéristique permet de distinguer l'origine du champ magnétique reçu par le ou les capteurs de champ magnétique (4) en analysant les différentes fréquences composant un ou plusieurs signaux. Elle permet la localisation simultanée de plusieurs sources de champ magnétique 3.

Dans une autre réalisation particulière de l'invention, la source de champ magnétique 3 est réalisée par le passage de courant électrique dans un solénoïde monocouche.

L'élément de mesure 2 peut, dans une réalisation particulière de l'invention, comporter un réseau de capteurs de champ magnétique 4. Les capteurs de champ magnétique 4 peuvent être placés en ligne et en colonne pour former une matrice.

Chaque capteur de champ magnétique 4 peut être fixé sans aucun degré de liberté aux autres capteurs de champ magnétique 4. A cet effet, les capteurs de champ magnétique 4 sont fixés sur la face supérieure d'un substrat rigide. Chaque capteur de champ magnétique 4 mesure le sens et l'intensité du champ magnétique généré par une ou plusieurs sources de champ magnétique 3 à l'emplacement du capteur. Pour cela, chaque capteur de champ magnétique 4 mesure la norme de la projection orthogonale du champ magnétique généré par la ou les sources de champ magnétique 3, à l'emplacement de ce capteur de champ magnétique 4, sur les trois axes de ce capteur de champ magnétique 4. Dans un exemple de réalisation, ces trois axes sont orthogonaux entre eux. Par exemple, un capteur de champ magnétique 4 va mesurer les composantes du champ magnétique sur des axes colinéaires à i,j et k.

Chaque capteur de champ magnétique 4 est raccordé à l'unité de traitement 7 par l'intermédiaire d'un bus 8 de transmission d'information.

L'unité de traitement 7 est capable de déterminer la position et/ou l'orientation de la ou des sources de champ dans le repère (i,j,k) de l'élément de mesure 2 à partir des mesures du ou des capteurs de champ magnétique 4. L'unité de traitement 7 comporte, entre autres, un ou plusieurs processeurs et mémoires. Le ou les processeurs sont programmés pour exécuter des instructions enregistrées dans la ou les mémoires.

En particulier, l'unité de traitement 7 associe un modèle mathématique avec l'ensemble ou à une partie des mesures des capteurs de champ magnétique 4 pour en déduire la position et/ou l'orientation de la ou des sources de champ magnétique 3.

L'unité de traitement 7 est aussi capable de restituer la localisation et/ou l'orientation d'une ou plusieurs sources de champ magnétique 3 à des plateformes numériques par l'intermédiaire de la sortie 9.

La figure 2 présente la description d'un modèle ampérien d'une source de champ magnétique 3. Ce modèle est utilisé par l'unité de traitement 7 de l'invention pour calculer la position et/ou l'orientation d'une ou plusieurs sources de champ magnétique 3 en fonction des mesures effectuées par les capteurs de champ magnétique 4.

Trémolet de Lacheisserie, É. *(Magnétisme: Fondements, tome I de Collection Grenoble Sciences. EDP Sciences,* 2000) montre que l'induction B générée par la matière aimantée et/ou par des courants électriques imposés de densité $j_0$ , en tout point de l'espace se ramène à un problème d'électromagnétisme du vide dans lequel deux types de courants sont à considérer :

- les courants réels (ou libres) de densité volumique $j_0$
- les courants associés à la matière aimantée (ou courants liés), de densité volumique $j_m$ et surfacique $j_{ms}$ données par :

$$j_m = \text{rot } \mathbf{M} \tag{1}$$

$$j_{ms} = \mathbf{M} \text{x} \mathbf{n} \tag{2}$$

où n est le vecteur unitaire normal à la surface de la matière aimantée illustrée en figure 2 et orienté vers l'extérieur de la source de champ magnétique 3 et M est l'aimantation en tout point de la matière aimantée. Cette équivalence est appelée modèle ampérien de l'aimantation.

La relation (1) indique que dans le cas d'une aimantation uniforme, $j_m$=0. Ainsi, un cylindre uniformément aimanté est équivalent à un solénoïde parcouru par une densité de courant surfacique $|j_{ms}|=|M|$.

La figure 3 illustre l'utilisation du théorème de superposition dans une modélisation utilisée dans l'invention. Dans un exemple de réalisation de l'invention, la source de champ magnétique 3 est un cylindre troué. On peut utiliser le théorème de superposition en ramenant le problème au calcul du champ magnétique généré par deux solénoïdes emboîtés (modèle ampérien) et parcourus par des courants surfaciques opposés. Le modèle ampérien peut être utilisé par l'unité de traitement 7 de l'invention pour calculer la position et/ou l'orientation d'une ou plusieurs sources de champ magnétique 3 en fonction des mesures effectuées par les capteurs de champ magnétique 4. Le calcul de l'induction générée par l'aimant cylindrique troué peut être fait en sommant les inductions générées par la superposition des inductions magnétiques des deux solénoïdes présentés dans la figure 3.

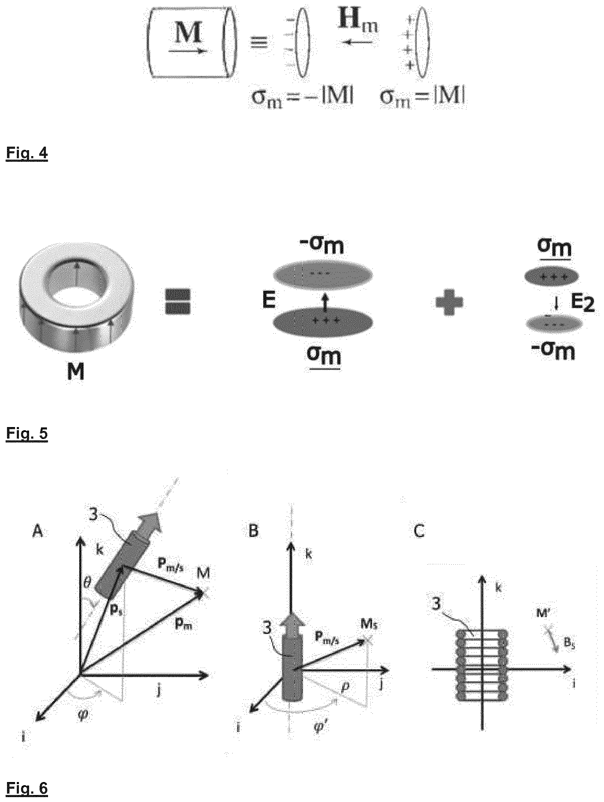

La figure 4 présente une description du modèle coulombien. Ce modèle peut être utilisé par l'unité de traitement 7 de l'invention, alternativement au modèle ampérien, pour calculer la position et l'orientation d'une ou plusieurs sources de champ magnétique 3 en fonction des mesures effectuées par les capteurs de champ magnétique 4. Trémolet de Lacheisserie, É. *(Magnétisme: Fondements, tome I de Collection Grenoble Sciences. EDP Sciences,* 2000) montre que le champ magnétique $\mathbf{H_m}$ produit par la matière aimantée est identique en tout point de l'espace à celui créé par des masses magnétiques fictives de densités volumique $\rho_m$ et surfacique $\sigma_m$ données par:

$$\rho_m = -div\, \mathbf{M} \tag{3}$$

$$\sigma_m = \mathbf{M}.\mathbf{n} \tag{4}$$

Le champ magnétique considéré est ici le champ magnétique dû à la matière (appelé parfois champ démagnétisant dans la matière aimantée, et champ de la matière hors de la matière aimantée). L'induction magnétique B s'obtient en prenant en compte le champ magnétique ambiant $H_0$ et l'aimantation M par la relation $\mathbf{B}=\mu_0(\mathbf{H_0}+\mathbf{H_m}+\mathbf{M}).$ Dans le cas d'un aimant de type FeNdB, le champ ambiant, supposé de l'ordre du champ magnétique terrestre dans cette réalisation de l'invention, sera négligé vis-à-vis de l'aimantation rémanente. Quand l'aimantation est uniforme, d'après (3), $\rho_m$=0 ; on peut caractériser l'aimantation par des densités de charge superficielle $\sigma_m$. Par exemple, le champ $\mathbf{H_m}$ créé (dans la matière et en dehors) par un cylindre uniformément aimanté le long de son axe est le même que celui engendré par deux disques de densités surfaciques uniformes $\sigma_m = \pm|M|$ et situés sur chacune des faces planes du cylindre.

La figure 5 illustre l'utilisation du théorème de superposition dans une modélisation utilisée dans l'invention. Dans un exemple de réalisation de l'invention, la source de champ magnétique 3 est un cylindre troué. On peut utiliser le théorème de superposition en ramenant le problème au calcul du champ généré par deux paires de disques chargés uniformément ($\sigma_m = \pm|M|$, modèle coulombien).

Durand E. (Electrostatique et Magnétostatique, Tome I : Les distributions, Edition Masson et Cie, p. 246 - 250) a présenté les calculs des inductions magnétiques générées pour des distributions de courants ou de masses magnétiques fictives, en particulier pour un solénoïde parcouru par un courant surfacique $j_{ms}$. Comme décrit précédemment, un solénoïde d'axe principal z parcouru par un courant surfacique $j_s$ est l'équivalent ampérien d'un aimant permanent cylindrique d'axe z, et d'aimantation uniforme $M = |js|z$. Ainsi, la connaissance de l'induction magnétique générée en tout point de l'espace par un solénoïde parcouru par un courant surfacique $j_s$ permet de calculer l'induction magnétique générée en tout point de l'espace par un aimant cylindrique d'aimantation uniforme $M = |js|z$.

En coordonnées cylindriques, le centre du repère étant le centre géométrique du solénoïde O, un point M étant repéré par ses coordonnées (r,θ,z), l'induction produite en tout point de l'espace par le solénoïde est indépendante de la variable θ en raison de la symétrie du problème. Les composantes $B_r$ et $B_z$ sont données par :

$$B_r = \frac{\mu_0 j_s}{2\pi k} \sqrt{\frac{a}{r}} \left[ (k^2 - 2)K(k^2) + 2E(k^2) \right]_{\xi^-}^{\xi^+} \qquad (5)$$

$$B_z = \frac{\mu_0 j_s}{4\pi} \frac{1}{\sqrt{ar}} zk \left[ K(k^2) + \frac{a-r}{a+r}\Pi(h^2, k^2) \right]_{\xi^-}^{\xi^+} \qquad (6)$$

avec :

$$k^2 = \frac{4ar}{(a+r)^2 + z^2} \qquad (7)$$

$$\xi^{+/-} = z \pm L/2 \qquad (8)$$

et K, E et Π les intégrales elliptiques complètes de la première, seconde et troisième espèce:

$$K(m) = \int_0^{\frac{\pi}{2}} \frac{1}{\sqrt{1 - m\sin^2\theta}} d\theta \qquad (9)$$

$$E(m) = \int_0^{\frac{\pi}{2}} \sqrt{1 - m\sin^2\theta} \, d\theta \qquad (10)$$

$$\Pi(n,m) = \int_0^{\frac{\pi}{2}} \frac{1}{(1 - n\sin^2\theta)\sqrt{1 - m\sin^2\theta}} d\theta \qquad (11)$$

Une des caractéristiques de l'invention est de combiner l'utilisation des modèles ampérien et/ou coulombien présentés ci-dessus avec une résolution des intégrales elliptiques (9), (10) et (11) par des algorithmes dit de Bulirsch (Bulirsch R., Numerical Calculation of Elliptic Integrals and Elliptic Functions, Numerische Mathematik 7, 78-90, 1965). Il s'agit d'algorithmes itératifs permettant l'évaluation de fonctions mathématiques communes, en l'occurrence des intégrales elliptiques, en utilisant le moins d'itérations possible.

Une implémentation avantageuse de cet algorithme, en termes d'efficacité, est présentée dans Derby, N., & Olbert, S. (2010), « Cylindrical magnets and ideal solenoids », American Journal of Physics, 78(3), 229-235. Cette implémentation permet de calculer la fonction C (pour Complete Elliptic Integral, c'est-à-dire intégrale elliptique complète) définie par :

$$C(k_c, p, c, s) = \int_0^{\pi/2} \frac{c\cos^2\varphi + s\sin^2\varphi}{(\cos^2\varphi + p\sin^2\varphi)\sqrt{\cos^2\varphi + k_c^2\sin^2\varphi}} d\varphi \qquad (12)$$

On peut alors réécrire les équations (5) et (6) selon les notations de Derby *et al.*:

$$B_r(\boldsymbol{M}) = B_0[\alpha_+ C(k_+, 1, 1, -1) - \alpha_- C(k_-, 1, 1, -1)] \qquad (13)$$

$$B_z(\boldsymbol{M}) = B_0 \frac{a}{a+\rho}[\beta_+ C(k_+, \gamma^2, 1, \gamma) - \beta_- C(k_-, \gamma^2, 1, \gamma)] \qquad (14)$$

$$B_0 = \frac{\|B_r\|}{\pi} = \frac{\|\mu_0 \boldsymbol{m}\|}{\pi V} \qquad (15)$$

$$\alpha_\pm = \frac{a}{\sqrt{z_\pm^2 + (\rho+a)^2}} \qquad (16)$$

$$\beta_\pm = \frac{z_\pm}{\sqrt{z_\pm^2 + (\rho+a)^2}} \qquad (17)$$

$$\gamma = \frac{a-\rho}{a+\rho} \qquad (18)$$

$$k_\pm = \sqrt{\frac{z_\pm^2 + (a-\rho)^2}{z_\pm^2 + (a+\rho)^2}} \qquad (19)$$

La fonction C peut être calculée efficacement en utilisant les algorithmes de Bulirsch, traduisant numériquement une transformation de Landen.
La publication de Bulirsch considère trois cas distincts. Dans le cas du calcul d'une intégrale complète de première espèce, qui peut s'écrire sous la forme :

$$cel1(k_c) = \int_0^\infty \frac{d\xi}{\sqrt{(1+\xi^2)(1+k_c^2\xi^2)}} \qquad (20)$$

l'algorithme traduit un calcul intégral numérique utilisant une transformation de Landen. Dans le cas d'une intégrale complète de seconde espèce (incluant le cas des intégrales de première espèce), qui peut s'écrire sous la forme :

$$cel2(k_c, a, b) = \int_0^\infty \frac{a+b\xi^2}{(1+\xi^2)\sqrt{(1+\xi^2)(1+k_c^2\xi^2)}} d\xi \qquad (21)$$

l'algorithme traduit aussi un calcul intégral numérique utilisant une transformation de Landen. On peut par ailleurs noter que pour un argument complexe de l'intégrale elliptique, la résolution des intégrales elliptiques de première et seconde espèce utilise une transformation de Gauss car la transformation de Landen n'est pas stable numériquement dans ce cas, mais la plupart des réalisations de l'invention utilisent des transformations de Landen.
Enfin, un troisième algorithme est proposé dans le cas d'une intégrale elliptique complète de troisième espèce, c'est-à-dire de la forme :

$$cel2(k_c, m, p) = \int_0^\infty \frac{1+\xi^2}{(1+p\xi^2)\sqrt{(1+\xi^2)(1+k_c^2\xi^2)}} d\xi \ . \qquad (22)$$

Ce troisième algorithme traduit lui aussi un calcul intégral numérique utilisant une transformation de Landen (alors que la forme plus générale, dans le cas d'une intégrale elliptique non complète est calculée en utilisant une transformation de Gauss). Dans les réalisations de l'invention, le calcul des intégrales K(m), E(n) et $\Pi$(n,m) ou C($k_c$, p, c, s) correspond au calcul d'intégrales complètes : les réalisations de l'invention utilisent des transformations de Landen pour calculer avantageusement ces intégrales.

Le calcul de la fonction C demande en moyenne cinq itérations pour converger à une précision de $10^{-12}$ ce qui peut permettre d'utiliser cette méthode pour modéliser, par exemple, le champ magnétique généré par des solénoïdes de tailles différentes sans utiliser l'approximation dipolaire. Les inventeurs ont découvert que l'utilisation de cette méthode de calcul du champ magnétique pouvait permettre de rendre la charge de calcul acceptable pour une unité de traitement usuelle, ou un processeur usuel, tout en modélisant le champ magnétique à des distances très proches de la ou des sources de champ magnétique. Par exemple, dans le cas d'une source magnétique d'une dimension caractéristique d'un centimètre, une réalisation de l'invention permet de modéliser le champ magnétique, grâce au calcul des intégrales elliptiques complètes par une transformation de Landen, à une distance inférieure à dix centimètres, ce qui est impossible en utilisant un modèle dipolaire des sources de champ magnétique. Lors de la mesure de la position et/ou de l'orientation relative d'une source de champ magnétique 3 par rapport à un capteur 4, il est possible de rapprocher la source 3 et le capteur 4 à une distance inférieure à 10 cm. Dans d'autres réalisations de l'invention, la modélisation du champ magnétique 3 est faite par un modèle coulombien. On peut calculer des intégrales elliptiques complètes équivalentes à K, E et $\Pi$ par les algorithmes de Bulirsch.

La figure 6 présente la mise en oeuvre du problème de calcul d'une source champ magnétique 3 dans un référentiel cartésien. Le panneau A de la figure 6 présente la configuration générique du problème de calcul du champ magnétique. Les résultats des expressions du champ magnétique obtenus par un algorithme de Bulirsch peuvent être mis en oeuvre pour calculer les coordonnées de l'induction magnétique **B** en un point M quelconque de l'espace à partir de la connaissance de paramètres de la source de champ magnétique 3 (moment magnétique, dimensions et position).

Les formules (13) à (19) sont exprimées dans le repère cylindrique local de la source de champ magnétique 3. Dans la figure 3, on traite un cas général où le repère absolu est quelconque.

Pour passer du repère global $\omega$**(O,i,j,k)** à un repère local relié au solénoïde **S(S,i',j',k')**, il faut effectuer une translation et deux rotations. La translation est effectuée avec le vecteur $\mathbf{p_s}$ puis une rotation autour de l'axe **k** permet de placer le solénoïde dans le plan **(ik)**. Enfin une rotation autour de j permet de dresser le solénoïde de telle façon que son axe soit confondu avec l'axe **k.** La position du point M dans le repère S est donnée par $\mathbf{M_s}$ :

$$M_S = R_y(-\theta)R_z(-\varphi)(OM - OS) \qquad (23)$$

Le point M est décrit dans le repère cartésien lié à la source magnétique.

Le panneau B de la figure 6 illustre l'alignement du moment magnétique avec l'axe **k.** On peut placer M sur le plan **(ik)** en appliquant une rotation à M. On obtient alors le point M' de coordonnées ($\rho$,0,z) données par :

$$M'(\rho, 0, z) = R_z(-\varphi')M_S \qquad (24)$$

L'effet de cette rotation est présenté par le panneau C de la figure 6. Une fois que p et z sont calculés, il est possible d'utiliser (16) et (17) pour calculer le champ magnétique au point projeté sur **(ik).** Une fois le champ magnétique calculé, on peut effectuer les rotations inverses afin de déterminer l'induction magnétique $\mathbf{B_w}$ dans le repère initial :

$$\mathbf{B}_\omega = R_z(\varphi)R_y(\varphi)R_z(\varphi')\big(B_\rho, 0, B_z\big) \qquad (25)$$

Dans des réalisations de l'invention, les matrices de rotation sont générées par des opérations géométriques ne faisant pas intervenir des fonctions trigonométriques de type arc cosinus ou arc tangente pour des raisons de stabilité numérique et de rapidité d'exécution matérielle.

On peut avantageusement utiliser une seconde méthode de passage du repère global $\omega$ au repère local S relié à la source de champ magnétique 3. On définit par $\mathbf{P_{m/s}} = \mathbf{OM}$ - $\mathbf{OS}$ la position relative du point de mesure M par rapport au centre du solénoïde S. On définit le vecteur **M** comme le moment de la source de champ magnétique 3 (colinéaire à l'axe de la source de champ magnétique 3). On définit $\mathbf{M_n} = \mathbf{M}/\|\mathbf{M}\|$ le moment normalisé de la source de champ magnétique 3. On définit $\mathbf{P_{m/s,n}} = \mathbf{P_{m/s}}/\|\mathbf{P}\|$ le vecteur unitaire de S vers M. Dans le repère cylindrique lié à la source de champ magnétique 3, les coordonnées du point M sont (x,y,z) = **(0,0,P.$\mathbf{M_n}$).** Le vecteur d'induction magnétique $\mathbf{B}_\omega$ dans le repère global $\omega$ est alors défini après le calcul du vecteur d'induction magnétique $\mathbf{B_s}$ dans le repère local S par $B_\omega = \mathbf{B_s}.\mathbf{M_n} + \mathbf{B_s}. (\mathbf{M_n} \times \mathbf{P_{m/s,n}} \times \mathbf{M_n}).$

L'invention utilise des méthodes d'estimation qui utilisent d'une part les modèles analytiques d'induction introduits précédemment, et d'autre part, des mesures issues de capteurs. L'utilisation conjointe de ces méthodes permet alors de calculer les positions et/ou les orientations relatives d'une ou plusieurs source(s) de champ magnétique 3 par rapport à un ou plusieurs capteurs de champ magnétique 4. Elle peut aussi être utilisée pour estimer la position et/ou l'orientation d'un ou plusieurs capteurs magnétiques 4 par rapport à une ou plusieurs sources de champ magnétique 3.

Dans les réalisation de l'invention, une étape intervient après l'acquisition des mesures du ou des capteurs de champ magnétique 4 et après le calcul par l'unité de traitement 7 de l'expression du champ magnétique 3 généré par au moins une source de champ magnétique 3 en modélisant les sources 3 par une superposition de solénoïdes et/ou une superposition de plans uniformément chargés, comme décrit précédemment. Cette étape consiste à estimer la localisation et/ou de l'orientation d'une source de champ magnétique 3 et/ou d'un capteur de champ magnétique 4 suivant une méthode choisie entre une optimisation, un filtrage bayésien ou une méthode hybride entre une optimisation et un filtrage bayésiens.

Dans le cas de l'optimisation, on cherche à trouver un vecteur de paramètres $\mathbf{x}$ (par exemple la position et/ou l'orientation de la source de champ magnétique 3, le moment magnétique de la source de champ magnétique 3, ou la position et/ou l'orientation du capteur de champ magnétique 4) qui minimisent un coût donné. En l'occurrence, l'optimisation consiste à minimiser les coûts entre les mesures desdits capteurs et les solutions calculées lors de la modélisation du champ magnétique. Par exemple, on peut utiliser la méthode des moindres carrées:

$$x = argmin_x\big((z - h(x))^T(z - h(x))\big) \qquad (26)$$

Ici $\mathbf{z}$ est la mesure réalisée par le/les capteurs de champ magnétique 4. $h(x) = B_\omega(x)$ est le modèle proposé dans la section précédente. Pour résoudre ce problème on peut par exemple utiliser la méthode de Gauss-Newton ou la méthode de Levenberg-Marquardt.

Dans le cas du filtre bayésien, on peut utiliser l'approximation Markovienne d'ordre 1 pour estimer la position d'une ou plusieurs sources de champ magnétique 3 par rapport à ou aux capteur(s) de champ magnétique ou inversement. Cette opération peut être effectuée en deux étapes :

- une prédiction utilisant l'état à l'instant précédent utilisant un modèle dynamique d'évolution d'état pour prédire l'état actuel,
- une mise à jour basée sur l'innovation apportée par les mesures données par les capteurs de champ magnétique 4 par rapport aux mesures prédites, calculées sur la base du modèle ampérien exposé précédemment.

De façon générale, pour estimer l'état *a posteriori à* partir d'un *a priori* et d'une mesure, le théorème de Bayes peut être utilisé:

$$P(\mathbf{x}_{t+1}|\mathbf{z}_{1:t+1}) = \frac{P(\mathbf{z}_{t+1}|\mathbf{x}_{t+1}, \mathbf{z}_{1:t})P(\mathbf{x}_{t+1}|\mathbf{z}_{1:t})}{P(\mathbf{z}_{t+1}|\mathbf{z}_{1:t})} = \frac{\mathbf{vraisemblance} \times \boldsymbol{a\ priori}}{\mathbf{\acute{e}vidence}} \qquad (27)$$

Le calcul de la vraisemblance fait intervenir une fonction h qui lie l'état à la mesure. Ici l'état est la position et/ou l'orientation de la source magnétique et la mesure est le champ magnétique mesuré par le ou les capteurs de champ magnétique 4. Ce principe s'applique à tous les estimateurs Bayésiens. En particulier, un filtre de Kalman peut être utilisé pour résoudre ce problème. Lors de ce calcul, on peut estimer le vecteur moment magnétique au lieu de l'orientation pour éliminer certains calculs trigonométriques.

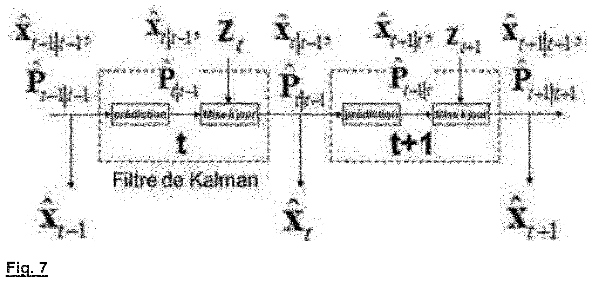

La figure 7 présente une vue schématique du fonctionnement d'un filtre de Kalman. Le filtre de Kalman, permet de trouver l'état à l'instant t+1 en fonction de l'état à l'instant précédant en deux opérations (prédiction et mise à jour). En particulier dans le cas où on utilise une fonction de mesure non linéaire (tel est le cas du modèle proposé), on peut recourir à la version étendue du filtre.

Dans un filtre de Kalman, l'état est décrit par les deux premiers moments de sa distribution de probabilité. Comme cette dernière est supposée Gaussienne, les deux moments sont suffisants pour la décrire complètement. On appelle $\overline{x}_{t+1}$ l'espérance de l'état et $P_{t+1}$ sa matrice de covariance.

Un filtre de Kalman est dit étendu s'il réutilise les mêmes équations utilisées dans un filtre de Kalman classique en linéarisant localement la fonction de mesure :

$$h(\mathbf{x}_{t+1}) = \mathbf{H}_{t+1}\mathbf{x}_{t+1} \qquad (28)$$

La fonction est calculée à partir de (25). $\mathbf{H_{t+1}}$ est la matrice jacobienne évaluée en $\overline{X}_{t+1|t}$. La phase de prédiction pour un modèle d'évolution statique est :

$$\begin{aligned}\bar{\mathbf{x}}_{t+1|t} &= \mathbf{F}\bar{\mathbf{x}}_{t|t}\\ \mathbf{P}_{t+1|t} &= \mathbf{F}\mathbf{P}_{t|t}\mathbf{F}^{\mathrm{T}} + \mathbf{Q}_t\end{aligned} \qquad (29)$$

où $\mathbf{F}$ est une matrice identité et $\mathbf{Q}$ est la matrice de covariance du bruit d'état. Elle décrit l'incertitude sur l'évolution de l'état. La phase de mise à jour permet d'utiliser le modèle proposé pour corriger la prédiction à partir de l'information apportée par la mesure actuelle, appelée innovation $\tilde{y}_{t+1}$. On a :

$$\begin{aligned}\bar{\mathbf{x}}_{t+1|t+1} &= \bar{\mathbf{x}}_{t+1|t} + \mathbf{K}_{t+1}\tilde{\mathbf{y}}_{t+1}\\ \mathbf{P}_{t+1|t+1} &= \mathbf{P}_{t+1|t} - \mathbf{K}_{t+1}\mathbf{H}_{t+1}\mathbf{P}_{t+1|t}\end{aligned} \qquad (30)$$

Ici, $H_{t+1} = \overline{V}_x[h(x_{t+1})]$ est la matrice jacobienne de la fonction de mesure h évaluée en $\bar{x}_{t+1|t}$. $K_{t+1}$ est le gain de Kalman. L'innovation et le gain de Kalman sont calculés comme suit :

$$\tilde{\mathbf{y}}_{t+1} = \mathbf{z}_{t+1} - \mathbf{h}(\bar{\mathbf{x}}_{t+1|t}) \qquad (31)$$

$$\mathbf{K}_{t+1} = \mathbf{P}_{t+1|t}\mathbf{H}_{t+1}{}^{\mathrm{T}}\mathbf{\Sigma}^{-1}_{\tilde{y}_{t+1}\tilde{y}_{t+1}} \qquad (32)$$

$$\mathbf{\Sigma}^{-1}_{\tilde{y}_{t+1}\tilde{y}_{t+1}} = \mathbf{H}_{t+1}\mathbf{P}_{t+1|t}\mathbf{H}_{t+1}{}^{\mathrm{T}} + \mathbf{R}_{t+1} \qquad (33)$$

Dans des réalisations de l'invention, la position et/ou l'orientation relative d'une source de champ 3 par rapport à la position et/ou l'orientation d'un capteur 4 sont calculées à partir d'un filtrage de Kalman tel que décrit précédemment. Le même principe s'applique pour le filtre de Kalman de type UKF, ainsi que les filtres à particules et tous les autres filtres Bayésiens.

On peut avantageusement utiliser un algorithme appelé LMA (décrit dans Aloui, S., Villien, C., & Lesecq, S. (2014), « A new approach for motion capture using magnetic field: models, algorithms and first results. » International Journal of Adaptive Control and Signal Processing) à la place du filtre de Kalman. Cette approche est basée sur l'utilisation d'un algorithme hybride Bayésien/Optimisation de type Levenberg-Marquard. Lors de l'utilisation de l'algorithme LMA, on effectue dans un premier temps une étape de prédiction, similaire à l'étape de prédiction décrite précédemment lors de l'utilisation d'un filtre de Kalman. Dans un deuxième temps, on effectue une étape de mise à jour, similaire à la méthode de Kalman décrite précédemment mais en remplaçant les équations d'optimisation du coût par :

$$\mathbf{x}_{t+1|t+1} = argmin\left(\begin{bmatrix}\mathbf{z}_{t+1} - \mathbf{h}(\mathbf{x}_{t+1|t+1})\\ \mathbf{x}_{t+1|t} - \mathbf{x}_{t+1|t+1}\end{bmatrix}^{\top}\begin{bmatrix}\mathbf{R}^{-1}_{t+1} & \mathbf{0}\\ \mathbf{0} & \mathbf{P}^{-1}_{t+1|t}\end{bmatrix}\begin{bmatrix}\mathbf{z}_{t+1} - \mathbf{h}(\mathbf{x}_{t+1|t+1})\\ \mathbf{x}_{t+1|t} - \mathbf{x}_{t+1|t+1}\end{bmatrix}\right) \quad (34)$$

Chaque itération $i \in \{1... n_i\}$ est calculée par :

$$x^i_{t+1|t+1} = x^{i-1}_{t+1|t+1} + \Delta^{i-1}_{t+1|t+1} \qquad (35)$$

où :

$$\Delta^{i-1}_{t+1|t+1} = \left[(\mathbf{P}^{i-1}_{t+1|t+1})^{-1} + \lambda^i \mathbf{diag}((\mathbf{P}^{i-1}_{t+1|t+1})^{-1})\right]^{-1}\mathbf{e}^{i-1} \qquad (36)$$

et :

$$\mathbf{e}^{i-1} = \left[ (\mathbf{H}_{t+1}^{i-1})^{\top} \mathbf{R}_{t+1}^{-1} \left( \mathbf{z}_t - \mathbf{h}\left( \mathbf{x}_{t+1|t+1}^{i-1} \right) \right) + (\mathbf{P}_{t+1|t})^{-1} \left( \mathbf{x}_{t+1|t} - \mathbf{x}_{t+1|t+1}^{i-1} \right) \right] \tag{37}$$

$$(\mathbf{P}_{t+1|t+1}^{i-1})^{-1} = \mathbf{H}_{t+1}^{i-1\top} \mathbf{R}_{t+1}^{-1} \mathbf{H}_{t+1}^{i-1} + (\mathbf{P}_{t+1|t})^{-1} \tag{38}$$

où $\lambda$ est le facteur d'amortissement, non constant. Le facteur d'amortissement est initialisé à $\lambda^0 = 1$. Pour chaque itération i, l'erreur $e^i = \|\mathbf{e}^i\|_2$ est calculée. Si $e^i < e^{i-1}$, $\mathbf{x}_{t+1|t}^i$ est laissé tel quel et $\lambda$ est diminué (par exemple $\lambda^{i+1} = \frac{\lambda^i}{10}$ ).

Sinon, $\mathbf{x}_{t+1|t}^i$ est rejeté ($\mathbf{x}_{t+1|t}^i = \mathbf{x}_{t+1|t}^{i-1}$) et $\lambda$ est augmenté (par exemple $\lambda^{i+1} = 10\lambda^i$).

La matrice de covariance de la distribution estimée *a posteriori* est $\mathbf{P}_{t+1|t+1} = \mathbf{P}_{t+1|t+1}^{n_i}$. Elle est calculée comme dans l'exemple précédent du filtre de Kalman. Cette méthode fait converger le calcul vers la borne de Cramér-Rao (borne minimale de l'erreur d'estimation).

## Revendications

1.  Procédé de détermination de la position relative dans l'espace d'au moins deux sources de champ magnétique (3) par rapport à au moins un capteur de champ magnétique (4), au moins une desdites sources de champ magnétique (3) étant un solénoïde, le procédé comprenant les étapes consistant à :

    a) acquérir des mesures du champ magnétique généré par lesdites sources de champ magnétique (3) au moyen dudit au moins un capteur de champ magnétique (4);
    b) calculer au moyen d'au moins un processeur une solution de l'expression du champ magnétique généré par les sources de champ magnétique (3) en modélisant chaque desdites sources de champ magnétique (3) par un élément choisi parmi une superposition de solénoïdes et une superposition de plans chargés, puis en estimant la valeur d'une intégrale elliptique complète liée au dit modèle par un algorithme itératif de Bulirsch utilisant une transformation de Landen ;
    c) calculer au moins un élément choisi parmi la position et l'orientation de chaque dite source de champ magnétique (3) en utilisant au moins une méthode choisie parmi :

    - une minimisation du coût entre lesdites mesures dudit au moins un capteur de champ magnétique (4) et lesdites solutions calculées à l'étape b) ;
    - un filtrage bayésien, à des instants successifs, de chaque dite mesure de chacun dudit au moins un capteur de champ magnétique (4), ledit filtrage étant fonction de chaque dite solution calculée à l'étape b), le procédé comprenant en outre la commande d'une émission périodique de l'intensité du champ magnétique dudit solénoïde à une fréquence différente d'au moins une autre desdites sources de champ magnétique (3).

2.  Procédé selon la revendication précédente dans lequel au moins le filtrage bayésien est choisi comme méthode pour l'étape c), ledit filtre bayésien étant un filtre de Kalman.

3.  Procédé selon l'une des revendications précédentes dans lequel au moins une desdites au moins deux sources de champ magnétique (3) est en mouvement par rapport au dit au moins un capteur de champ magnétique (4) et dans lequel au moins un élément choisi parmi la position et l'orientation d'au moins une desdites au moins deux sources de champ magnétique (3) et la position et l'orientation dudit au moins un capteur de champ magnétique (4) est calculé à partir d'un filtrage de Kalman desdites mesures dudit au moins un capteur capteur de champ magnétique (4), ledit filtrage de Kalman étant fonction de chaque dite solution calculée, à chacun desdits instants successifs.

4.  Procédé selon l'une des revendications précédentes dans lequel au moins une desdites au moins deux sources de champ magnétique (3) peut être placée à moins de dix centimètres dudit au moins un capteur de champ magnétique (4).

5.  Interface homme/machine comportant au moins deux sources de champ magnétique (3), au moins une desdites sources de champ magnétique (3) étant un solénoïde, au moins un capteur de champ magnétique (4), et au moins une unité de traitement (7) programmée de manière opportune pour la mise en oeuvre de chaque étape de l'une des revendications précédentes.

6. Interface homme/machine selon la revendication précédente comportant une pluralité de capteurs de champ magnétique (4) formant dans leur ensemble un réseau non plan.

7. Interface homme/machine selon l'une des revendications 5 à 6 dans laquelle au moins une desdites au moins deux sources de champ magnétique (3) est choisie parmi un solénoïde monocouche et un aimant cylindrique plein.

8. Interface homme/machine selon l'une des revendications 5 à 7 dans laquelle au moins une desdites au moins deux sources de champ magnétique (3) est un aimant permanent composé d'un alliage d'éléments choisis parmi le fer, le vanadium, le néodyme, le bore, l'aluminium, le nickel, le titane, le cuivre, le samarium et le cobalt.

**Patentansprüche**

1. Verfahren zum Bestimmen der relativen Position von mindestens zwei Magnetfeldquellen (3) im Raum in Bezug auf mindestens einen Magnetfeldsensor (4), wobei mindestens eine der Magnetfeldquellen (3) ein Solenoid ist, wobei das Verfahren die folgenden Schritte umfasst:

   a) Erfassen von Messwerten des von den Magnetfeldquellen (3) erzeugten Magnetfelds mithilfe des mindestens einen Magnetfeldsensors (4);
   b) Berechnen, mit mindestens einem Prozessor, einer Lösung des Ausdrucks des von den Magnetfeldquellen (3) erzeugten Magnetfelds durch Modellieren jeder der Magnetfeldquellen (3) durch ein Element ausgewählt aus einer Überlagerung von Solenoiden und einer Überlagerung von Ladungsebenen, dann Schätzen des Wertes eines vollständigen elliptischen Integrals, verbunden mit dem Modell mittels eines iterativen Bulirsch-Algorithmus unter Verwendung einer Landen-Transformation;
   c) Berechnen mindestens eines Elements ausgewählt aus der Position und der Orientierung jeder Magnetfeldquelle (3) unter Anwendung mindestens einer Methode ausgewählt aus:

      - einer Minimierung der Kosten zwischen den Messwerten des mindestens einen Magnetfeldsensors (4) und den in Schritt b) berechneten Lösungen;
      - einer Bayes'schen Filterung jedes Messwertes von jedem der mindestens einen Magnetfeldsensoren (4) zu aufeinanderfolgenden Zeitpunkten, wobei die Filterung eine Funktion jeder der in Schritt b) berechneten Lösungen ist,

   wobei das Verfahren ferner das Steuern einer periodischen Sendung der Intensität des Magnetfelds des Solenoids bei einer unterschiedlichen Frequenz von mindestens einer anderen der Magnetfeldquellen (3) umfasst.

2. Verfahren nach dem vorherigen Anspruch, wobei mindestens die Bayes'sche Filterung als Methode für Schritt c) gewählt wird, wobei das Bayes'sche Filter ein Kalman-Filter ist.

3. Verfahren nach einem der vorherigen Ansprüche, wobei mindestens eine der mindestens zwei Magnetfeldquellen (3) relativ zu dem mindestens einen Magnetfeldsensor (4) in Bewegung ist und wobei mindestens ein Element ausgewählt aus der Position und Orientierung mindestens einer der mindestens zwei Magnetfeldquellen (3) und der Position und Orientierung des mindestens einen Magnetfeldsensors (4) auf der Basis einer Kalman-Filterung der Messungen des mindestens einen Magnetfeldsensors (4) berechnet wird, wobei die Kalman-Filterung eine Funktion jeder berechneten Lösung zu jedem der aufeinanderfolgenden Zeitpunkte ist.

4. Verfahren nach einem der vorherigen Ansprüche, wobei mindestens eine der mindestens zwei Magnetfeldquellen (3) in einem Abstand von weniger als zehn Zentimeter von dem mindestens einen Magnetfeldsensor (4) platziert werden kann.

5. Mensch-Maschine-Schnittstelle, die mindestens zwei Magnetfeldquellen (3), wobei mindestens eine der Magnetfeldquellen (3) ein Solenoid ist, mindestens einen Magnetfeldsensor (4) und mindestens eine Verarbeitungseinheit (7) umfasst, die geeignet zur Durchführung jedes Schrittes von einem der vorherigen Ansprüche programmiert ist.

**6.** Mensch-Maschine-Schnittstelle nach dem vorherigen Anspruch, die eine Vielzahl von Magnetfeldsensoren (4) umfasst, die in ihrer Gesamtheit ein nicht-planares Netzwerk bilden.

**7.** Mensch-Maschine-Schnittstelle nach einem der Ansprüche 5 bis 6, wobei mindestens eine der mindestens zwei Magnetfeldquellen (3) aus einem einschichtigen Solenoid und einem zylindrischen Vollmagneten ausgewählt ist.

**8.** Mensch-Maschine-Schnittstelle nach einem der Ansprüche 5 bis 7, wobei mindestens eine der mindestens zwei Magnetfeldquellen (3) ein Permanentmagnet ist, der aus einer Legierung von Elementen ausgewählt aus Eisen, Vanadium, Neodym, Bor, Aluminium, Nickel, Titan, Kupfer, Samarium und Kobalt besteht.

**Claims**

**1.** A method for determining the relative position in space of at least two magnetic field sources (3) in relation to at least one magnetic field sensor (4), at least one of the magnetic field sources (3) being a solenoid, the method comprising the steps of:

a) acquiring measurements of the magnetic field generated by said magnetic field sources (3) by means of said at least one magnetic field sensor (4);
b) computing, by means of at least one processor, a solution of the expression of the magnetic field generated by the magnetic field sources (3) by modelling each said magnetic field source (3) by an element chosen from among a superposition of solenoids and a superposition of charged planes, then by estimating the value of a complete elliptic integral linked to said model by an iterative Bulirsch algorithm using a Landen transformation;
c) computing at least one element chosen from among the position and the orientation of each said magnetic field source (3) by using at least one method chosen from among:

- a minimisation of the cost between said measurements of said at least one magnetic field sensor (4) and said solutions computed in step b);
- a Bayesian filtering, at successive instants, of each said measurement of each said at least one magnetic field sensor (4), said filtering being a function of each said solution computed in step b),

the method further comprising the command of a periodic emission of the intensity of the magnetic field of said solenoid at a different frequency from at least one other of said magnetic field sources (3).

**2.** The method according to the preceding claim, wherein at least the Bayesian filtering is chosen as method for step c), said Bayesian filter being a Kalman filter.

**3.** The method according to one of the preceding claims, wherein at least one of said at least two magnetic field sources (3) is in motion in relation to said at least one magnetic field sensor (4) and wherein at least one element chosen from among the position and the orientation of at least one of said at least two magnetic field sources (3) and the position and the orientation of said at least one magnetic field sensor (4) is computed from a Kalman filtering of said measurements of said at least one magnetic field sensor (4), said Kalman filtering being a function of each said computed solution, at each of said successive instants.

**4.** The method according to one of the preceding claims, wherein at least one of said at least two magnetic field sources (3) can be placed less than ten centimetres away from said at least one magnetic field sensor (4).

**5.** A human/machine interface comprising at least two magnetic field sources (3), at least one of the magnetic field sources (3) being a solenoid, at least one magnetic field sensor (4), and at least one processing unit (7) programmed appropriately to implement each step of one of the preceding claims.

**6.** The human/machine interface according to the preceding claim, comprising a plurality of magnetic field sensors (4) forming, as a whole, a non-planar array.

**7.** The human/machine interface according to one of claims 5 to 6, wherein at least one of said at least two magnetic field sources (3) is chosen from among a single layer solenoid and a solid cylindrical magnet.

**8.** The human/machine interface according to one of claims 5 to 7, wherein at least one of said at least two magnetic field sources (3) is a permanent magnet composed of an alloy of elements chosen from among iron, vanadium, neodyme, boron, aluminium, nickel, titanium, copper, samarium and cobalt.

**Fig. 1**

**Fig. 2**

**Fig. 3**

$$\sigma_m = -|M| \qquad \sigma_m = |M|$$

Fig. 4

Fig. 5

Fig. 6

**Fig. 7**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4785242 A
- WO 2013144342 A
- EP 2889648 A1
- EP 2378305 A1

**Littérature non-brevet citée dans la description**

- **YAN, L. et al.** An Orientation Measurement Method Based on Hall-effect Sensors for Permanent Magnet Spherical Actuators with 3D Magnet Array. *Scientific reports,* 2014, vol. 4
- **MARTIN SCHEPERS H et al.** Ambulatory human motion tracking by fusion of intertial and magnetic sensing with adaptive actuation. *Médical & biological engineering & computing,* 17 Décembre 2009, vol. 48 (1), 27-37
- **DURAND E.** Les distributions. *Electrostatique et Magnétostatique,* 246-250
- **BULIRSCH R.** Numerical Calculation of Elliptic Integrals and Elliptic Functions. *Numerische Mathematik,* 1965, vol. 7, 78-90
- **DERBY, N. ; OLBERT, S.** Cylindrical magnets and ideal solenoids. *American Journal of Physics,* 2010, vol. 78 (3), 229-235
- **ALOUI, S. ; VILLIEN, C. ; LESECQ, S.** A new approach for motion capture using magnetic field: models, algorithms and first results. *International Journal of Adaptive Control and Signal Processing,* 2014